(19) Europäisches Patentamt
European Patent Office
Office européen des brevets

(11) **EP 1 948 716 B1**

(12) **EUROPEAN PATENT SPECIFICATION**

(45) Date of publication and mention
of the grant of the patent:
**06.03.2013 Bulletin 2013/10**

(51) Int Cl.:
**C08G 83/00** (2006.01)   **C08L 101/00** (2006.01)
**B81C 1/00** (2006.01)

(21) Application number: **06821377.6**

(22) Date of filing: **08.11.2006**

(86) International application number:
**PCT/IB2006/054169**

(87) International publication number:
**WO 2007/054903 (18.05.2007 Gazette 2007/20)**

(54) **HYPERBRANCHED POLYMER FOR MICRO DEVICES**

HYPERVERZWEIGTES POLYMER FÜR MIKROGERÄTE

POLYMERE HYPER-RAMIFIE POUR MICRODISPOSITIFS

(84) Designated Contracting States:
**AT BE BG CH CY CZ DE DK EE ES FI FR GB GR HU IE IS IT LI LT LU LV MC NL PL PT RO SE SI SK TR**

(30) Priority: **08.11.2005 PCT/IB2005/053671**

(43) Date of publication of application:
**30.07.2008 Bulletin 2008/31**

(73) Proprietors:
• **ECOLE POLYTECHNIQUE FEDERALE DE LAUSANNE (EPFL)**
**1015 Lausanne (CH)**
• **Korea Advanced Institute of Science and Technology**
**305-701 Daejeon (KR)**

(72) Inventors:
• **SCHMIDT, Lars**
**8048 Zürich (CH)**
• **LETERRIER, Yves**
**CH-1007 Lausanne (CH)**
• **MANSON, Jan-Anders**
**CH-1071 Chexbres (CH)**
• **CHO, Young-Ho**
**Daejeon 305-761 (KR)**

• **JIN, Young-Hyun**
**Seoul 138-798 (KR)**

(74) Representative: **Grosfillier, Philippe**
**ANDRE ROLAND SA**
**Chemin des Charmettes 9**
**P.O. Box 5107**
**1002 Lausanne (CH)**

(56) References cited:
**WO-A-01/59030          WO-A-2005/084191**
**DE-A1- 10 311 163**

• **SANGERMANO MARCO ET AL: "Investigation on the effect of the presence of hyperbranched polymers on thermal and mechanical properties of an epoxy UV-cured system" POLYM. INT.; POLYMER INTERNATIONAL JUNE 2005, vol. 54, no. 6, June 2005 (2005-06), pages 917-921, XP002451611**
• **SCHMIDT LARS E ET AL: "Photorheology of fast UV-curing multifunctional acrylates" MACROMOL. MATER. ENG.; MACROMOLECULAR MATERIALS AND ENGINEERING NOV 4 2005, vol. 290, no. 11, 4 November 2005 (2005-11-04), pages 1115-1124, XP002449674**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Field of the invention

The invention relates to micro devices such as microfluidic devices which are at least partially made of polymers.

### Background of the invention

The term hyperbranched polymers (HBP) used herein refers to dendrimers, hyperbranched macromolecules and other dendron-based architectures and derivatives of all of them, and their reactive blends with multifunctional polymers.
The term "micro" used herein indifferently refers to applications and objects having a micrometer or nanometer scale.
Polymers offer numerous advantages for microfluidic applications, like ease of fabrication, using replication process, and biocompatibility. Polymer-based devices are cheap enough to be disposable. Polymer materials such as polycarbonate, polyimide, polymethylmethacrylate, polydimethylsiloxane (PDMS), and cyclic olefin copolymer (COC) have been explored for micro devices. See for example international patent application WO 2004/007582. Among them, PDMS and COC are the most widely used in recent studies. PDMS structures can be fabricated [1-6] by a very simple micromolding (casting) process using SU-8 photoresist patterns as a master. However, the curing process of PDMS takes more than 2 hours at elevated temperature (85°C). The mechanical properties [7] such as Young's modulus (0.3~9 MPa) and glass transition temperature (-125 °C) are comparatively low, and residual strain after curing process (~ 5%) [8] is relatively high. PDMS has a hydrophobic surface, which sometimes limits its applicability for microfluidic devices. Plasma treatment [9-11] changes the surface property into hydrophilic, but its effect is temporary (not more than a few days). In contrast COC exhibits good mechanical properties. Microfluidic devices [12, 13] were recently fabricated using a COC injection molding process. However, these processes are carried out at high pressure (~0.55 MPa) and high temperature (>100°C) inducing high levels of internal stress. Process induced internal strains (or stresses) are the result of thermal contraction and shrinkage due to solvent removal and network formation. Room temperature fabrication process like an UV-curing process can easily solve the thermal contraction problem. Recent studies suggest the usage of hyperbranched polymers (HBP) as pure products or in reactive blends for network formation shrinkage and stress reduction [14-16]. This class of dendritic macromolecules has been studied as modifiers in a vast range of thermosetting systems [17-19], and to some extent in photosetting polymers [20-22].
DE 103311163 describes the use of hyperbranched polymers for modifying surfaces in order to reduce the adsorption of proteins, cells, bacteria and/or viruses. The surface can be part of a biochip in a microfluidic system.
WO 2005/084191 concerns a microfluidic device comprising a hyperbranched perfluorpolyether liquid precursor.
WO 01/59030 relates to a dendritic polymer used in microelectronic devices such as light emitting devices.

### Summary of the invention

The present invention relates to the manufacture of microstructures relevant for micro and nano-engineering applications, such as microchips, microfluidic and other lab-on-a-chip devices. It is characterized by the fact that the microstructures are at least made of a hyperbranched polymer. The present invention shows, however, that there are nevertheless significant and unexpected advantages in using this class of polymeric materials. Particularly, the suitability of novel UV-curable HBPs for fast and low temperature fabrication of microfluidic devices using a polydimethylsiloxane (PDMS) master is compared to PDMS and cyclic olefin copolymer (COC). The thermal, mechanical, and surface properties of the cured HBP are advantageous compared to the PDMS, with glass transition temperatures above room temperature, appropriate for microfluidic applications at room temperature. The achieved minimum patterns, stress level, shape fidelity are advantageous compared to COC. The hydrophilic nature of the HBP and its short manufacture time are also extremely advantageous compared to both PDMS and COC. Fluidic filling test were successfully carried out on the fabricated devices.

### Object and detailed description of the invention

The objective underlying the present invention is to propose a novel HBP material for micro devices, such as microfluidic devices, and to characterize the suitability of the HBP for the fabrication of microfluidic devices. The present HBP can be UV curable, which provides fast curing process at room temperature. It exhibits low polymerization shrinkage at moderate Young's modulus. And its glass transition temperature is above room temperature, so the fabricated device is mechanically stable at room temperature. A further potential of the HBPs is its hydrophilic nature, while other polymers used for such applications (for instance PDMS and COC) are hydrophobic.

## Brief description of figures

**Fig.1.** Fabrication process of the fluidic devices using Acrylated Polyether HBP and a PDMS master: (a) PDMS molding for a master; (b) UV curing of the Acrylated Polyether HBP; (c) bonding with a PDMS cover for the fluidic interconnections.

**Fig.2.** SEM images of the smallest Acrylated Polyether HBP structures: (a) 14.5$\mu$m-wide and 33$\mu$m-high wall structure; (b) 14.67$\mu$m-wide and 33$\mu$m-deep channel structure.

**Fig.3.** SEM images of the smallest Acrylated Polyether HBP structures: (a) 20$\mu$m square pillars (33$\mu$m-high); (b) 35$\mu$m square holes (33$\mu$m-deep).

**Fig.4.** Fabricated devices: (a) fluidic digital-to-analog converters: (b) enlarged view of the section A in Fig.4(a).

**Fig.5.** SEM images of the fabricated devices: (a) section B in Fig.4(b); (b) section C in Fig.5(a).

**Fig.6.** Fluidic filling test of the fabricated devices: (a) water is injected through inlet port; (b) water is filling approach channel; (c) water is filling microchannel without any bubble; (d) water is flowing out through outlet port.

## Hyperbranched polymers

The term hyperbranched polymers (HBP) used herein refers to dendrimers, hyperbranched macromolecules and other dendron-based architectures and derivatives of all of them, and their reactive blends with multifunctional polymers. HBPs can generally be described as three-dimensional highly branched molecules having a tree-like structure. They are characterized by a great number of end groups, which can be functionalized with tailored groups to ensure compatibility and reactivity. The dendritic or "tree-like" structure shows regular symmetric branching from a central multifunctional core molecule leading to a compact globular or quasi-globular structure with a large number of end groups per molecule. Hyperbranched polyesters have been described by Malmström et al. (Macromolecules 28, (1997) 1698). Whereas the dendrimers require stepwise synthesis and can be costly and time consuming to produce, hyperbranched polymers can be prepared by a simple condensation of molecules of type $AB_m$, and usually) a $B_f$ functional core. This results in an imperfect degree of branching and some degree of polydispersity, depending on the details of the reaction. Hyperbranched polymers nevertheless conserve the essential features of dendrimers, namely a high degree of end-group functionality and a globular architecture, at an affordable cost for bulk applications (Hawker and Frechet, ACS Symp. Ser. 624, (1996) 132; Frechet et al., J. Macromol. Sci.-Pure Appl. Chem. A33, (1996) 1399; Tomalia and Durst, Top. Curr. Chem. 165, (1993) 193).

In general, dendritic polymers such as dendrimers and hyperbranched polymers have an average of at least 16 end groups per molecule for 2nd generation materials, increasing by a factor of at least 2 for each successive generation or pseudo-generation, certain dendritic polymers having up to 7 or more generations. The exemplary Boltorn™ polymers used as precursors for the HBPs in the examples provided herein is commercially available up to a 4 pseudo-generations. Number average molar masses of 2 generation or pseudo-generation dendrimers or hyperbranched polymers are usually greater than about 1500 g/mol, and the molar masses increases exponentially in generation or pseudo-generation number, reaching about 8000 g/mol for a 4 pseudo-generation polymer such as 4-generation Boltorn™. Typically the molecular weight of the dendrimers will be about 100 g/mol per end group, although this will vary according to the exact formulation.

The HBPs used in the present invention are therefore distinguished from conventional highly branched polymers which may have as many end groups, but have a much higher molar mass and a much less compact structure. The HBPs are distinguished from compact highly branched species that are produced during intermediate steps in the cure of a thermoset (epoxy, for example), as these latter polymers have a very broad molar mass distribution and hence an ill-defined molar mass. Dendrimers have a single well-defined molar mass and hyperbranched polymers have well defined molar mass averages and a relatively narrow molecular weight distribution, for example having a polydispersity which is less than 5.0 and more preferably is less than 2.0.

An example of commercially available HBPs are Boltorn™ polymers from Perstorp Chemicals. They are derived from the polycondensation of 2,2 bis-hydroxymethyl propionic acid (*bis*MPA) with a tetrafunctional ethoxylated pentaerythritol core, as described by Malmström *et al.*. The different grades are referred to using a pseudo-generation number by analogy with perfect dendrimers, where the $n^{th}$ pseudo-generation corresponds to a reaction mixture containing

$$4\sum_{i=0}^{n-1}2^i$$

*bisMPA* molecules for every core molecule. A two pseudo-generation unmodified Boltorn™ HBP has a number average of 16 -OH functional groups per molecule, a three pseudo-generation unmodified Boltorn™ HBP has a number average of 32 -OH functional groups per molecule and a four pseudo-generation unmodified Boltorn™ HBP has a number average of 64 -OH functional groups per molecule. Unmodified HBPs of this type are glassy solids at room temperature, and combined size exclusion chromatography (SEC) and viscosity measurements in different solvents indicate a narrow molecular weight distribution and a weak dependence of the intrinsic viscosity on the molar mass, consistent with a molecular architecture close to that of a perfect dendrimer.

Because of their symmetrical or near symmetrical highly branched structure, HBPs show considerable differences in behaviour to, and considerable advantages over linear or conventional branched polymers, as well as monomers and low molar mass molecules with comparable chemical structures. HBPs can be formulated to give a very high molecular weight but a very low viscosity, making them suitable as components in compositions such as coatings so as to increase the solids content and hence reduce volatiles, whilst maintaining processability. HBPs can be used in the preparation of products constituting or being constituents of alkyd resins, alkyd emulsions, saturated polyesters, unsaturated polyesters, epoxy resins, phenolic resins, polyurethane resins, polyurethane foams and elastomers, binders for radiation curing systems such as systems cured with ultraviolet (UV) light, infrared (IR) light or electron beam irradiation (EB), dental materials, adhesives, synthetic lubricants, microlithographic coatings and resists, binders for powder systems, amino resins, composites reinforced with glass, aramid or carbon/graphite fibers and moulding compounds based on urea-formaldehyde resins, melamine-formaldehyde resins or phenol-formaldehyde resins. By adapting their shell chemistry they can be compatibilised with a given thermoset, photoset or thermoplastic matrix and function. simultaneously as processing aids, adhesion promoters, modifiers of interfacial or surface tension, toughening additives or low stress additives. They can be compatibilised with or made reactive with two or more components of a heterogeneous multicomponent polymer-based system to improve adhesion and morphological stability.

Other suitable polymers for producing microstructure patterns include HBPs modified by grafting linear chain arms to, or growing linear chains from their end groups. More generally, any type of star shaped or star branched polymer, in which linear or branched polymer arms are attached to a multifunctional core, or any related architecture, is suitable for the present application.

**Alternative HBP Formulations**

The nucleus of the HBP molecule is preferentially selected from a group consisting of a mono, di, tri or poly functional alcohol, a reaction product between a mono, di, tri or poly functional alcohol and ethylene oxide, propylene oxide, butylene oxide, phenylethylene oxide or combinations thereof, a mono, di, tri or poly functional epoxide, a mono, di, tri or poly functional carboxylic acid or anhydride, a hydroxy functional carboxylic acid or anhydride. Constituent mono, di, tri or poly functional alcohols are exemplified by 5-ethyl-5-hydroxymethyl-1,3-dioxane, 5,5-dihydroxymethyl-1,3-dioxane, ethylene glycol, diethylene glycol, triethylene glycol, propylene glycol, dipropylene glycol, pentanediol, neopentyl glycol, 1,3-propanediol, 2-methyl-2-propyl-1,3-propanediol, 2-ethyl-2-butyl-1,3-propanediol, cyclohexanedimethanol, trimethylolpropane, trimethylolethane, glycerol, erythritol, anhydroennea-heptitol, ditrimethylolpropane, ditrimethylolethane, pentaerythritol, methylglucoside, dipentaerythritol, tripentaerythritol, glucose, sorbitol, ethoxylated trimethylolethane, propoxylated trimethylolethane, ethoxylated trimethylolpropane, propoxylated trimethylolpropane, ethoxylated pentaerythritol or propoxylated pentaerythritol.

**Chain Termination and Functionalisation of HBPs**

Chain termination of a HBP molecule is preferably obtained by addition of at least one monomeric or polymeric chain stopper to the HBP molecule. A chain stopper is then advantageously selected from the group consisting of an aliphatic or cycloaliphatic saturated or unsaturated monofunctional carboxylic acid or anhydride having 1-24 carbon atoms, an aromatic monofunctional carboxylic acid or anhydride, a diisocyanate, an oligomer or an adduct thereof, a glycidyl ester of a monofunctional carboxylic or anhydride having 1-24 carbon atoms, a glycidyl ether of a monofunctional alcohol with 1-24 carbon atoms, an adduct of an aliphatic or cycloaliphatic saturated or unsaturated mono, di, tri or poly functional carboxylic acid or anhydride having 1-24 carbon atoms, an adduct of an aromatic mono, di, tri or poly functional carboxylic acid or anhydride, an epoxide of an unsaturated monocarboxylic acid or corresponding triglyceride, which acid has 3-24 carbon atoms and an amino acid. Suitable chain stoppers are, for example, formic acid, acetic acid, propionic acid, butanoic acid, hexanoic acid, acrylic acid, methacrylic acid, crotonic acid, lauric acid, linseed fatty acid, soybean fatty acid, tall oil fatty acid, dehydrated castor fatty acid, capric acid, caprylic acid, benzoic acid, para-tert.butyl benzoic acid, abietic acid, sorbic acid, 1-chloro-2,3-epoxypropane, 1,4-dichloro-2,3-epoxybutane, epoxidized soybean fatty acid, trimethylol propane diallyl ether maleate, toluene-2,4-diisocyanate, toluene-2,6-diisocyanate, hexamethylene diisocyanate, phenyl isocyanate and/or isophorone diisocyanate. It is emphasized that the aforementioned chain stoppers include compounds with or without functional groups. A functionalization of a dendritic polymer molecule (with or without chain termination) is preferably a nucleophilic addition, anoxidation, an epoxidation using an epihalohydrin such as epichlorohydrin, an allylation using an allylhalide such as allylchloride and/or allyl bromide, or a combination thereof. A suitable nucleophilic addition is, for example, a Michael addition of at least one unsaturated anhydride, such as maleic anhydride. Oxidation is preferably performed by means of an oxidizing agent. Preferred oxidizing agents include peroxy acids or anhydrides and haloperoxy acids or anhydrides, such as peroxyformic acid, peroxyacetic acid, peroxybenzoic acid, m-chloroperoxybenzoic acid, trifluoroperoxyacetic acid or mixtures thereof, or therewith. Oxidation may thus result in, for example, primary and/or secondary epoxide groups. To summarize, functionalization refers to addition or formation of functional groups and/or transformation of one type of functional groups into another type. Functionalization includes nucleophilic addition, such as Michael addition, of compounds having functional groups, epoxidation/oxidization of hydroxyl groups, epoxidation of alkenyl groups, allylation of hydroxyl groups, conversion of an epoxide group to anacrylate or methacrylate group, decomposition of acetals and ketals, grafting and the like.

The novel polymer-based microstructures according to the invention are constituted of at least an hyperbranched polymer (HBP). This HBP preferably contains acrylate functions, and is preferably processed using UV light and suitable photoinitiators, either as a pure compound, or as a reactive blend with other polymers, preferably those based on acrylates. The HBP may be chemically modified to impart additional functionality to the material in question, such as fluorescent groups, biologically active groups, compatibilizing groups, surface active groups or any other required function, depending on the application in question. The HBP may also be blended with reactive or non-reactive inorganic fillers, such as silica particles, mineral fillers, conductive and electrically active fillers, or any other required filler, depending on the application in question.

## Examples

The following examples pertain to acrylated HBPs and their reactive blends with multifunctional acrylates, but other suitable HBP architectures with appropriate end functionality including epoxy and thiol are possible.

### Example 1: Acrylated Polyether HBP microstructures

A 3rd generation hyperbranched polyether polyol (synthesized by Perstorp AB, Sweden) giving a 29-functional polyether acrylate (called Acrylated Polyether HBP) was used. The Polyether HBP was synthesized by ring opening polymerization of alkoxylated TMPO derivatives (3-ethyl-3-(hydroxymethyl)oxetane, Perstorp AB, Sweden) [23]. Acrylation was carried out according to the conventional preparation of acrylic esters by condensing polyol with acrylic acid. A detailed description of the photocuring kinetics of this material can be found elsewhere [24]. The photoinitiator used was Irgacure 500 (a mixture of equal parts of 1-hydroxy-cyclohexyl-phenyl-ketone (CAS 947-19-3, M = 204.26 g/mol) and benzophenone (CAS 119-61-9, M = 182.22 g/mol), supplied by Ciba Specialty Chemicals), at a concentration equal to 2 wt.-%. It is blended with the acrylate monomer at a temperature of 85°C to facilitate mixing. The UV curing of the monomer was carried out at an intensity of 22.2 mW/cm$^2$ (365 nm) for 3 min.

The water contact angle of cured Acrylated Polyether HBP and PDMS were determined as $53.9 \pm 2.4°$ and $112.6 \pm 2.9°$, respectively, using a GBX Contact Angle Meter. It is verified that the Acrylated Polyether HBP has a hydrophilic surface while PDMS has a hydrophobic surface. From the additional contact angle measurement of the Acrylated Polyether HBP with non-polar liquid (hexadecane) and Owens-Wendt-geometric mean, we calculated the dispersive (non-polar) and the polar the surface energy of the Acrylated Polyether HBP as $27.44 \pm 0.03$ mN/m and $21.86 \pm 1.60$ mN/m, respectively.

In addition, the glass transition temperature ($T_g$) of the Acrylated Polyether HBP was measured performing dynamic mechanical analysis using a three-point-bending set-up and rectangular samples in a Rheometric Scientific RSA dynamic mechanical analyzer. Tests were performed at an excitation frequency of 1 Hz and a heating rate of 10 K/min. The Tg was determined from the peak of $\tan(\delta)$ and found to be equal to 55°C, thus the Acrylated Polyether HBP is mechanically stable at room temperature.

Normally, photoresist patterns on silicon wafers are used as a master for polymer micromolding process. In order to facilitate demolding, a soft PDMS master, which could be peeled off, was used instead.

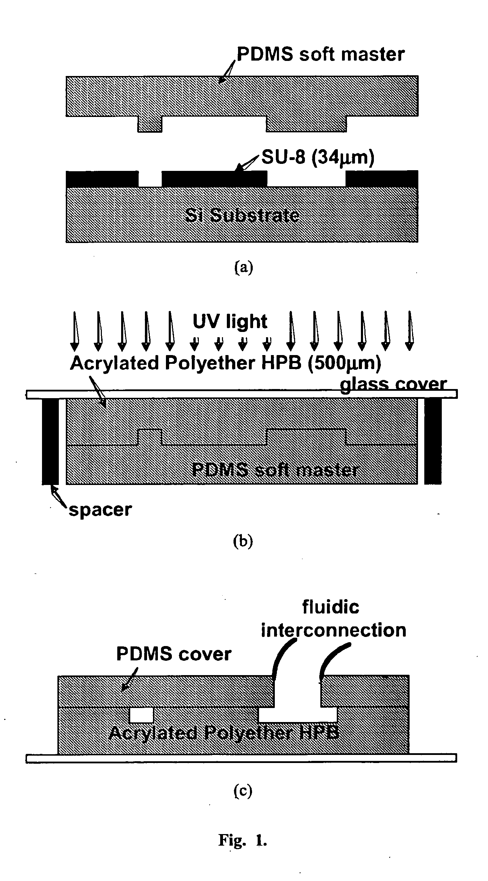

Figure 1 shows the fabrication process: Firstly, the PDMS master is fabricated in a molding process, using an SU-8 micropattern on a Si wafer (Figure 1a). The molding of the Acrylated Polyether HBP is carried out at 85°C and vacuum is applied to remove air inclusions. The thickness of the monomer layer is controlled using spacers and a glass cover, as depicted in Figure 1b. The monomer is exposed for three minutes at an intensity of 22.2 mW/cm$^2$. Thereafter

the soft master is carefully peeled off. Final step is making fluidic interconnections (Figure 1c). We bond the Acrylated Polyether HBP and the punched PDMS cover by plasma treatment using high frequency generator, BS-10AS (Electro-Technic Products, INC).

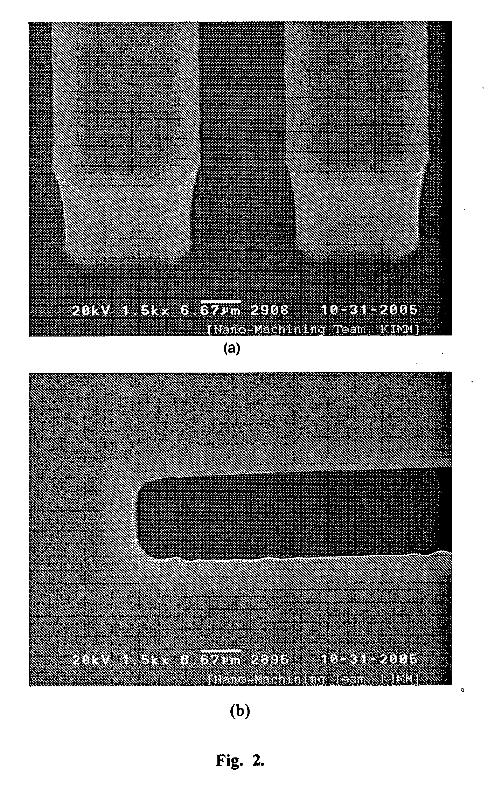

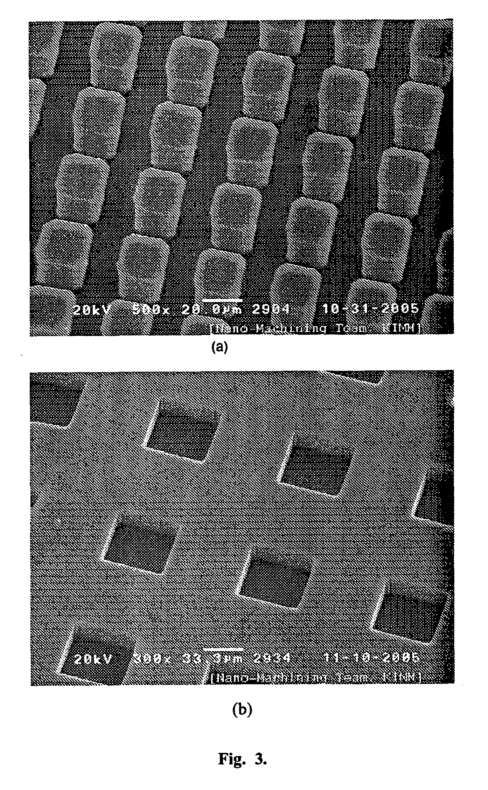

A number of experiments for the resolution test are carried out in order to validate the fabrication process. Test patterns include straight walls, straight channels, square and circular pillars and holes. The pattern sizes are from 5 $\mu$m up to 500 $\mu$m in 5 $\mu$m intervals. The fabricated smallest Acrylated Polyether HBP straight walls and channels are shown in Figure 2. The width of the smallest wall is 14.5 $\mu$m (designed as 15 $\mu$m) at the height of 33.1 $\mu$m (Figure 2a), giving an aspect ratio of 2.28. The smallest channel width is measured as 14.7 $\mu$m (designed as 15 $\mu$m) and depth as 33.1 $\mu$m (Figure 2b). If the channel is narrower than 15 $\mu$m, the PDMS master pattern broke and remained in the channel pattern. Figure 3a shows the smallest square pillars fabricated, having dimensions of 24.1 $\mu$m $\times$ 24.1 $\mu$m $\times$ 33.1 $\mu$m (A$\times$B$\times$H). The smallest circular pillars have a diameter of 24.3 $\mu$m and are 33.1 $\mu$m high. The size of the smallest hole is larger than that of the pillar: 53.4 $\mu$m $\times$ 53.4 $\mu$m $\times$ 33.1 $\mu$m (A$\times$B$\times$H) square holes as shown in Figure 3b. The smallest circular holes are of the same size. Table 1 lists the minimum dimensions of the fabricated structures. The patterning limitation of the positive structures (walls and pillars) comes from the high viscosity of the uncured Acrylated Polyether HBP. The high viscous liquid monomer cannot fill perfectly the narrow channels or holes in the PDMS master, thus we cannot fabricate positive structures smaller than 15 $\mu$m-wide walls or 25 $\mu$m-wide pillars. On the other hand, the failure of the PDMS master limits the smallest negative structures (channels and holes).

**Table 1.** Minimum dimensions measured from fabricated Acrylated Polyether HBP structures.

| Structure | Wall | Channel | Pillar | Hole |
|---|---|---|---|---|
| width (designed value) | 14.5 $\mu$m (15 $\mu$m) | 14.7 $\mu$m (15 $\mu$m) | 24.1 $\mu$m (25 $\mu$m) | 53.4 $\mu$m (55 $\mu$m) |
| height | 33.1 $\mu$m | | | |

## Example 2: fluidic digital-to-analog converter

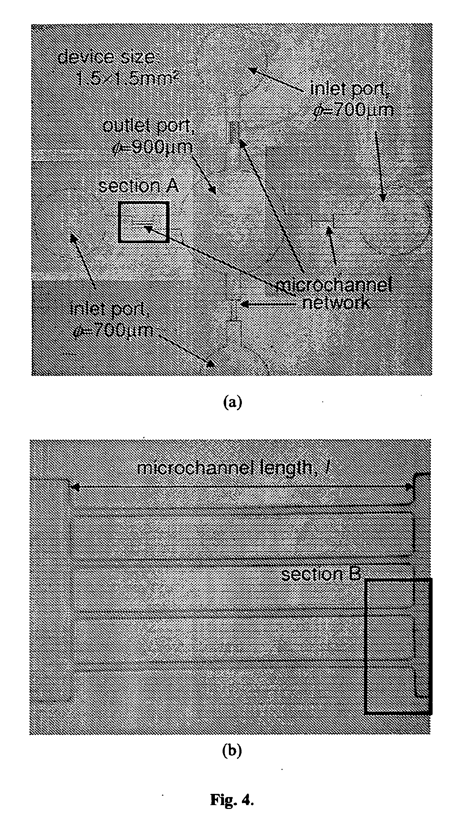

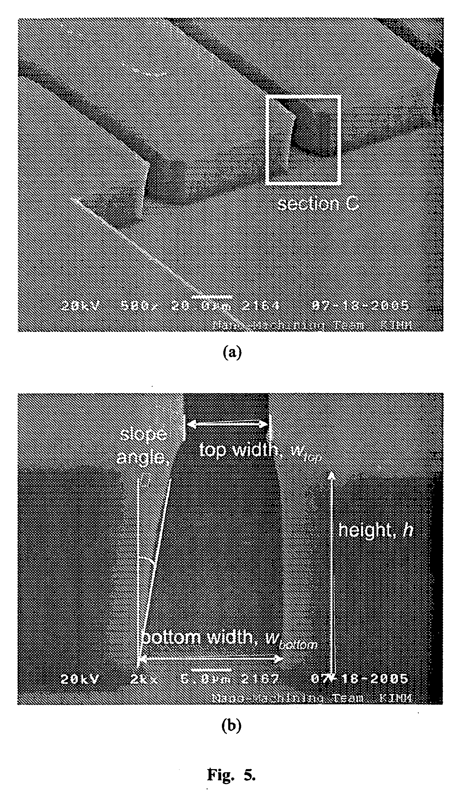

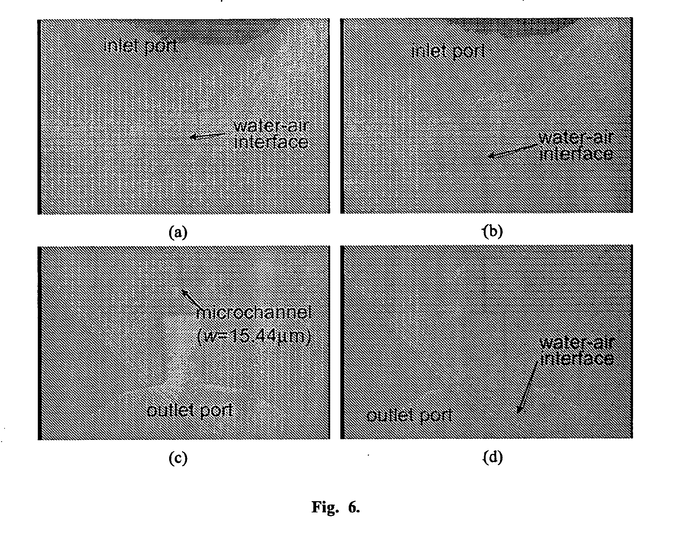

A fluidic digital-to-analog converter [25] was fabricated using the novel process (Figure 1) with Acrylated Polyether HBP detailed in example 1. The microscopic view of the overall fabricated device is shown in Figure 4a. The chip size was 1.5 mm x 1.5 mm and it consists of four inlet ports, one outlet port and four microchannel networks. Figure 4b shows the microscopic view of a microchannel network. The length of the microchannel is measured as 605.6$\pm$3.2 $\mu$m. SEM images of the microchannel cross-section are shown in Figure 5. We compare designed and fabricated dimensions of the microchannel in Table 2. The error in slope angle, 6.6 °, results from the PDMS master fabrication step. We observe the SU-8 pattern for the PDMS master (Figure 1a) has a similar slop angle. Because of the slope angle, the top and bottom part of the microchannel have different widths, measured as 15.44 $\pm$ 0.88 $\mu$m and 22.67 $\pm$ 1.43 $\mu$m, respectively (Table 2). A fluidic filling test was carried out in order to verify the functionality of the fabricated devices. Water was injected through the inlet port at a flow rate of 0.5 $\mu$l/min by a syringe pump. The injected water flowed successfully through the 15.44 $\mu$m-wide microchannel (Figure 6) without any bubbles or water leakage occurring.

**Table 2.** Designed and fabricated microchannel dimensions of the fluidic digital-to-analog converters.

| Microchannel Parameters | | Designed Dimensions | Fabricated Dimensions |
|---|---|---|---|
| length, $l$ (Fig.6(b)) | | 600$\mu$m | 605.6$\pm$3.2$\mu$m |
| width, $w$ (Fig 7(b)) | top, $w_{top}$ | 20$\mu$m | 15.44$\pm$0.88$\mu$m |
| | Bottom, $w_{bottom}$ | | 22.67$\pm$1.43$\mu$m |
| height, h (Fig.7(b)) | | 30$\mu$m | 31.24$\pm$2.39$\mu$m |
| slope angle, $\alpha$ (Fig.7(b)) | | 0° | $\approx$6.6° |

## Summary

Table 3 summarises and compares the material properties, fabrication process and fabricated pattern size of polymer materials for microfluidic applications. The Acrylated Polyether HBP shows higher Young's modulus, lower residual strain, higher surface energy and higher glass transition temperature than PDMS. Compared to COC, the Acrylated Polyether HBP has superior surface property. The Young's modulus and glass transition temperature of the Acrylated Polyether HBP is lower than that of COC, but these are high enough for the microfluidic applications. The process time of both PDMS and COC are long and the process temperature is above 85 °C. And PDMS needs more than 2 hours of curing. However, UV curing process of the Acrylated Polyether HBP is performed at room temperature for less than 3 minutes. Thus, Acrylated Polyether HBP provides low temperature and fast fabrication process. The linewidth of the Acrylated Polyether HBP in this research is about 15 $\mu$m, which is comparable to that of COC and worse than that of PDMS. If we consider that channel size of microfluidic devices is normally several tens of micrometer, the Acrylated Polyether HBP and its fabrication process is applicable to microfluidic devices. The limitation of the fabrication process lies on the covering and fluidic interconnection step. We use a PDMS cover for fluidic interconnections, and it provides hydrophobic surface different from channel surface.

The suitability of a novel UV-curable Acrylated Polyether HBP for fabricating microfluidic devices was demonstrated. Since the present polymer has Young's modulus of 770 MPa, residual strain of 0.2 % and glass transition temperature of 55 °C, it is mechanically stable at room temperature. Moreover, the new polymer has hydrophilic surface, which is advantageous to microfluidic applications. The UV-curing fabrication process of the present polymer is fast (less than 3 minutes) and is carried out at room temperature. Aspect ratios of more than two were achieved for walls and channels and one for pillars and holes. We successfully demonstrated microfluidic devices and verify the functionality of the fabricated devices. Therefore the present polymer and its fabrication process is a good alternative for microfluidic applications.

Table 3. Material properties, fabrication process and pattern size comparison of the polymer materials for the microfluidic applications.

| Material | Material properties | | | | Fabrication process | | | Pattern size | |
|---|---|---|---|---|---|---|---|---|---|
| | Young's modulus | Residual strain | Contact angle | Glass transition Temperature | Process name | Process temperature | Process time | Linewidth | Aspect ratio |
| Acrylated Polyether HBP | 770MPa | 0.2% | 53.9° | 55°C | Micro molding | 20°C (R.T.) | < 3 min. | ~ 15μm | ~ 2.5 |
| PDMS | 0.3~9MPa [7] | ~ 5% [8] | 112.6° | -125°C [7] | Casting | 85°C | > 2hrs | ~ 2μm | ~ 10 |
| COC | 2.6-3.2GPa [12] | N.A. | 92° [12] | 80~180°C [12] | Injection molding | 125°C | < 1 min. | ~ 20μm | ~ 5 |

**References**

[1] S. Chang and Y.-H. Cho, J. Micromech. Microeng. 2005, 15, 1397.
[2] I. Doh and Y.-H. Cho, Sensor. Actuat. A-Phys. 2005, 121, 59.
[3] D. W. Lee, S. Y. Yi, and Y.-H. Cho. An integrated micro cell counting and concentration sensing chip. in Ninth International Conference on Miniaturized Systems for Chemistry and Life Sciences (μTAS). 2005. Boston.
[4] A. Tourovskaia, X. Figueroa-Masot, and A. Folch, Lab Chip 2005, 5, 14.
[5] T. Park, S. Lee, G. H. Seong, J. Choo, E. K. Lee, Y. S. Kim, W. H. Ji, S. Y. Hwang, D.-G. Gweon, and S. Lee, Lab Chip 2005, 5, 437.
[6] K. Ramser, J. Enger, M. Goksör, D. Hanstorp, K. Logg, and M. Käll, Lab Chip 2005,5,431.
[7] J. C. Lötters, W. Olthuis, P. H. Veltink, and P. Bergveld, J. Micromech. Microeng. 1997, 7, 145.
[8] A. Govindaraju, A. Chakraborty, and C. Luo, J. Micromech. Microeng. 2005, 15, 1303.
[9] R. A. Lawton, C. R. Price, A. F. Runge, W. J. Doherty III, and S. S. Saavedra, Colloid Surface A 2005, 253, 213.
[10] T. Murakami, S.-I. Kuroda, and Z. Osawa, J. Colloid. Interf. Sci. 1998, 202, 37.
[11] C. Donzel, M. Geissler, A. Bernard, H. Wolf, B. Michel, J. Hilborn, and E. Delamarche, Adv. Mater. 2001, 13, 1164.
[12] C. H. Ahn, J.-W. Choi, G. Beaucage, J. H. Nevin, J.-B. Lee, A. Puntambekar, and J. Y. Lee, P. IEEE 2004, 92, 154.
[13] C.-C. Hong, J.-W. Choi, and C. H. Ahn, Lab Chip 2004, 4, 109.
[14] J. E. Klee, C. Schneider, D. Hölter, A. Burgath, H. Frey, and R. Mülhaupt, Polym. Advan. Technol. 2001, 12, 346.
[15] H.-G. Kou, A. Asif, and W.-F. Shi, Chinese J. Chem. 2003,21,91.
[16] Q. Wan, S. R. Schricker, and B. M. Culbertson, J. Macromol. Sci. Pure 2000, A37,1317.
[17] Y. Eom, L. Boogh, V. Michaud, and J.-A. E. Månson, Polym Composite 2002, 23, 1044.
[18] R. Mezzenga, C. J. G. Plummer, L. Boogh, and J.-A. E. Månson, Polymer 2000, 42,305.
[19] M. Sangermano, G. Malucelli, R. Bongiovanni, A. Priola, A. Harden, and N. Rehnberg, Polym. Eng. Sci. 2003, 43, 1460.
[20] G. Xu and W. Shi, Prog. Org. Coat. 2005, 52,110.
[21] M. Johansson, T. Glauser, G. Rospo, and A. Hult, J. Appl. Polym. Sci. 2000, 75, 612.
[22] H. Claesson, E. Malmström, M. Johansson, A. Hult, M. Doyle, and J.-A. E. Månson, Prog. Org. Coat. 2002, 44, 63.
[23] H. Magnusson, E. Malmström, and A. Hult, Macromol. Rapid Commun. 1999, 20,453.
[24] L. E. Schmidt, Y. Leterrier, D. Schmäh, J.-A. E. Månson, D. James, E. Gustavsson, and L. S. Svensson, submitted to J. Appl. Polym. Sci. 2006,
[25] S.-H. Yoon and Y.-H. Cho, J. Microelectromech. S. 2006, 15, 967.

**Claims**

1. Micro device **characterized by** the fact that it is at least partially made of a molded acrylated polyether hyperbranched polymer whose glass transition temperature is above room temperature.

2. Micro device according to claim 1 **characterized by** the fact that it is a microfluidic device.

3. Micro device according to claim 1 or 2, wherein said hyperbranched polymer is UV curable.

4. Micro device according to anyone of the previous claims wherein the nucleus of the molecule constituting the hyperbranched polymer is preferentially selected from a group consisting of a mono, di, tri or poly functional alcohol, a reaction product between a mono, di, tri or poly functional alcohol and ethylene oxide, propylene oxide, butylene oxide, phenylethylene oxide or combinations thereof, a mono, di, tri or poly functional epoxide, a mono, di, tri or poly functional carboxylic acid or anhydride, a hydroxy functional carboxylic acid or anhydride.

5. Micro device according to anyone of the previous claims wherein said hyperbranched polymer is chemically modified in such a way as to also comprise fluorescent groups and/or biologically active groups and/or compatibilizing groups and/or surface active groups and/or any other required function depending on the intended purpose.

6. Micro device according to anyone of the previous claims wherein said hyperbranched polymer is blended with reactive or non-reactive inorganic fillers, such as silica particles, mineral fillers, conductive and electrically active fillers, or any other required filler, depending on the intended purpose.

**Patentansprüche**

1. Mikrovorrichtung, **dadurch gekennzeichnet, dass** sie zumindest teilweise aus einem geformten hyperverzweigten acrylierten Polyetherpolymer, dessen Glasübergangstemperatur über Raumtemperatur liegt, besteht.

2. Mikrovorrichtung nach Anspruch 1, **dadurch gekennzeichnet, dass** es sich um eine Mikrofluidikvorrichtung handelt.

3. Mikrovorrichtung nach Anspruch 1 oder 2, wobei das hyperverzweigte Polymer UV-härtbar ist.

4. Mikrovorrichtung nach einem der vorhergehenden Ansprüche, wobei der Kern des das hyperverzweigte Polymer bildenden Moleküls vorzugsweise aus der Gruppe bestehend aus einem mono-, di-, tri- order polyfunktionellen Alkohol, einem Reaktionsprodukt eines mono-, di-, tri- oder polyfunktionellen Alkohols und Ethylenoxid, Propylenoxid, Butylenoxid, Phenylethylenoxid oder Kombinationen davon, einem mono-, di-, tri- oder polyfunktionellen Epoxid, einer mono-, di-, tri- oder polyfunktionullen Carbonsäure oder einem Anhydrid davon und einer hydroxyfunktionellen Carbonsäure oder einem Anhydrid davon ausgewählt ist.

5. Mikrovorrichtung nach einem der vorhergehenden Ansprüche, wobei das hyperverzweigte Polymer derart chemisch modifiziert ist, dass es auch fluoreszierende Gruppen und/oder biologisch aktive Gruppen und/oder verträglichmachende Gruppen und/oder oberflächenaktive Gruppen und/oder eine beliebige andere geforderte Funktion je nach dem vorgesehenen Zweck umfasst.

6. Mikrovorrichtung nach einem der vorhergehenden Ansprüche, wobei das hyperverzweigte Polymer mit reaktiven oder unreaktiven anorganischen Füllstoffen, wie Siliciumdioxdteilchen, mineralischen Füllstoffen, leitfähigen und elektrisch aktiven Füllstoffen, oder einem beliebigen anderen geforderten Füllstoff je nach dem vorgesehenen Zweck gemischt ist.

**Revendications**

1. Microdispositif **caractérisé par le fait qu'**il est au moins partiellement constitué d'un polymère hyperramifié de polyéther acrylé moulé dont la température de transition vitreuse est supérieure à la température ambiante.

2. Microdispositif selon la revendication 1 **caractérisé par le fait qu'**il s'agit d'un dispositif microfluidique.

3. Microdispositif selon la revendication 1 ou 2, dans lequel ledit polymère hyperramifié est durcissable aux UV.

4. Microdispositif selon l'une quelconque des revendications précédentes dans lequel le noyau de la molécule constituant le polymère hyperramifié est de préférence choisi dans un groupe constitué par un alcool mono-, di-, tri- ou polyfonctionnel, un produit de réaction entre un alcool mono-, di-, tri- ou polyfonctionnel et l'oxyde d'éthylène, l'oxyde de propylène, l'oxyde de butylène, l'oxyde de phényl-éthylène ou des combinaisons de ceux-ci, un époxyde mono-, di-, tri- ou polyfonctionnel, un acide ou anhydride carboxylique mono-, di-, tri- ou polyfonctionnel, et un acide ou anhydride carboxylique hydroxyfonctionnel.

5. Microdispositif selon l'une quelconque des revendications précédentes dans lequel ledit polymère hyperramifié est modifié chimiquement de manière à comprendre également des groupes fluorescents et/ou des groupes biologiquement actifs et/ou des groupes compatibilisants et/ou des groupes tensioactifs et/ou toute autre fonction nécessaire, selon l'usage prévu.

6. Microdispositif selon l'une quelconque des revendications précédentes dans lequel ledit polymère hyperramifié est mélangé avec des charges inorganiques réactives ou non réactives telles que des particules de silice, des charges minérales, des charges conductrices et électriquement actives, ou toute autre charge nécessaire, selon l'usage prévu.

PDMS soft master

SU-8 (34µm)

Si Substrate

(a)

UV light

Acrylated Polyether HPB (500µm)

glass cover

PDMS soft master

spacer

(b)

fluidic
interconnection

PDMS cover

Acrylated Polyether HPB

(c)

Fig. 1.

EP 1 948 716 B1

(a)

(b)

Fig. 2.

12

(a)

(b)

Fig. 3.

(a)

(b)

**Fig. 4.**

(a)

(b)

Fig. 5.

(a)

(b)

(c)

(d)

Fig. 6.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2004007582 A
- DE 103311163
- WO 2005084191 A
- WO 0159030 A

### Non-patent literature cited in the description

- **MALMSTRÖM et al.** *Macromolecules,* 1997, vol. 28, 1698
- **HAWKER ; FRECHET.** *ACS Symp. Ser.,* 1996, vol. 624, 132
- **FRECHET et al.** *J. Macromol. Sci.-Pure Appl. Chem.,* 1996, vol. A33, 1399
- **TOMALIA ; DURST.** *Top. Curr. Chem.,* 1993, vol. 165, 193
- **S. CHANG ; Y.-H. CHO.** *J. Micromech. Microeng.,* 2005, vol. 15, 1397
- **I. DOH ; Y.-H. CHO.** *Sensor. Actuat. A-Phys.,* 2005, vol. 121, 59
- **D. W. LEE ; S. Y. YI ; Y.-H. CHO.** An integrated micro cell counting and concentration sensing chip. *Ninth International Conference on Miniaturized Systems for Chemistry and Life Sciences (μTAS,* 2005
- **A. TOUROVSKAIA ; X. FIGUEROA-MASOT ; A. FOLCH.** *Lab Chip,* 2005, vol. 5, 14
- **T. PARK ; S. LEE ; G. H. SEONG ; J. CHOO ; E. K. LEE ; Y. S. KIM ; W. H. JI ; S. Y. HWANG ; D.-G. GWEON ; S. LEE.** *Lab Chip,* 2005, vol. 5, 437
- **K. RAMSER ; J. ENGER ; M. GOKSÖR ; D. HANSTORP ; K. LOGG ; M. KÄLL.** *Lab Chip,* 2005, vol. 5, 431
- **J. C. LÖTTERS ; W. OLTHUIS ; P. H. VELTINK ; P. BERGVELD.** *J. Micromech. Microeng.,* 1997, vol. 7, 145
- **A. GOVINDARAJU ; A. CHAKRABORTY ; C. LUO.** *J. Micromech. Microeng.,* 2005, vol. 15, 1303
- **R. A. LAWTON ; C. R. PRICE ; A. F. RUNGE ; W. J. DOHERTY III ; S. S. SAAVEDRA.** *Colloid Surface A,* 2005, vol. 253, 213
- **T. MURAKAMI ; S.-I. KURODA ; Z. OSAWA.** *J. Colloid. Interf. Sci.,* 1998, vol. 202, 37
- **C. DONZEL ; M. GEISSLER ; A. BERNARD ; H. WOLF ; B. MICHEL ; J. HILBORN ; E. DELAMARCHE.** *Adv. Mater.,* 2001, vol. 13, 1164
- **C. H. AHN ; J.-W. CHOI ; G. BEAUCAGE ; J. H. NEVIN ; J.-B. LEE ; A. PUNTAMBEKAR ; J. Y. LEE.** *P. IEEE,* 2004, vol. 92, 154
- **C.-C. HONG ; J.-W. CHOI ; C. H. AHN.** *Lab Chip,* 2004, vol. 4, 109
- **J. E. KLEE ; C. SCHNEIDER ; D. HÖLTER ; A. BURGATH ; H. FREY ; R. MÜLHAUPT.** *Polym. Advan. Technol.,* 2001, vol. 12, 346
- **H.-G. KOU ; A. ASIF ; W.-F. SHI.** *Chinese J. Chem.,* 2003, vol. 21, 91
- **Q. WAN ; S. R. SCHRICKER ; B. M. CULBERTSON.** *J. Macromol. Sci. Pure,* 2000, vol. A37, 1317
- **Y. EOM ; L. BOOGH ; V. MICHAUD ; J.-A. E. MÅNSON.** *Polym Composite,* 2002, vol. 23, 1044
- **R. MEZZENGA ; C. J. G. PLUMMER ; L. BOOGH ; J.-A. E. MÅNSON.** *Polymer,* 2000, vol. 42, 305
- **M. SANGERMANO ; G. MALUCELLI ; R. BONGIOVANNI ; A. PRIOLA ; A. HARDEN ; N. REHNBERG.** *Polym. Eng. Sci.,* 2003, vol. 43, 1460
- **G. XU ; W. SHI.** *Prog. Org. Coat.,* 2005, vol. 52, 110
- **M. JOHANSSON ; T. GLAUSER ; G. ROSPO ; A. HULT.** *J. Appl. Polym. Sci.,* 2000, vol. 75, 612
- **H. CLAESSON ; E. MALMSTRÖM ; M. JOHANSSON ; A. HULT ; M. DOYLE ; J.-A. E. MÅNSON.** *Prog. Org. Coat.,* 2002, vol. 44, 63
- **H. MAGNUSSON ; E. MALMSTRÖM ; A. HULT.** *Macromol. Rapid Commun.,* 1999, vol. 20, 453
- **L. E. SCHMIDT ; Y. LETERRIER ; D. SCHMÄH ; J.-A. E. MÅNSON ; D. JAMES ; E. GUSTAVSSON ; L. S. SVENSSON.** *J. Appl. Polym. Sci.,* 2006
- **S.-H. YOON ; Y.-H. CHO.** *J. Microelectromech.,* 2006, vol. 15, 967